(19) Europäisches Patentamt
European Patent Office
Office européen des brevets

(11) **EP 2 191 607 B1**

(12) **EUROPÄISCHE PATENTSCHRIFT**

(45) Veröffentlichungstag und Bekanntmachung des Hinweises auf die Patenterteilung:
**04.05.2011 Patentblatt 2011/18**

(21) Anmeldenummer: **08785654.8**

(22) Anmeldetag: **20.08.2008**

(51) Int Cl.:
*H04L 7/033* (2006.01)   *H03L 7/14* (2006.01)

(86) Internationale Anmeldenummer:
**PCT/EP2008/006849**

(87) Internationale Veröffentlichungsnummer:
**WO 2009/039923 (02.04.2009 Gazette 2009/14)**

(54) **VERFAHREN UND VORRICHTUNG ZUR TAKTRÜCKGEWINNUNG**

METHOD AND DEVICE FOR CLOCK RECOVERY

PROCÉDÉ ET DISPOSITIF DE RÉCUPÉRATION D'HORLOGE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **21.09.2007 DE 102007045085**
**02.04.2008 DE 102008016897**

(43) Veröffentlichungstag der Anmeldung:
**02.06.2010 Patentblatt 2010/22**

(73) Patentinhaber: **Rohde & Schwarz GmbH & Co. KG 81671 München (DE)**

(72) Erfinder:
• **VILLARINO-VILLA, Rubén 80333 München (DE)**
• **KUHWALD, Thomas 85570 Markt Schwaben (DE)**
• **FREIDHOF, Markus 85614 Kirchseeon (DE)**

(74) Vertreter: **Körfer, Thomas et al Mitscherlich & Partner Patent- und Rechtsanwälte Postfach 33 06 09 80066 München (DE)**

(56) Entgegenhaltungen:
**EP-A- 0 312 671     EP-A- 1 076 416
GB-A- 2 359 223     JP-A- 7 058 790
US-A- 4 771 250**

• **ABRAMOVITCH D ED - AMERICAN AUTOMATIC CONTROL COUNCIL INSTITUTE OF ELECTRICAL AND ELECTRONICS ENGINEERS: "Phase-locked loops: a control centric tutorial" PROCEEDINGS OF THE 2002 AMERICAN CONTROL CONFERENCE. ACC. ANCHORAGE, AL, MAY 8 - 10, 2002; [AMERICAN CONTROL CONFERENCE], NEW YORK, NY : IEEE, US, Bd. 1, 8. Mai 2002 (2002-05-08), Seiten 1-15, XP010597074 ISBN: 978-0-7803-7298-6**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Taktrückgewinnung gemäß dem Oberbegriff des unabhängigen Patentanspruchs 1 und eine zugehörige Vorrichtung.

TECHNISCHER HINTERGRUND UND STAND DER TECHNIK

In der digitalen Übertragungstechnik werden manche binären Datenströme, insbesondere serielle Datenströmen mit hoher Bitrate, ohne begleitendes Taktsignal gesendet. Ziel der Taktrückgewinnung (Englisch: Clock Data Recovery CDR) ist, aus dem empfangenen Datenstrom die Frequenz und Phase des unterliegenden Sendetakts zu ermitteln.

In einem üblichen Empfänger dient das zurückgewonnene Sendetakt- oder Clucksignal der Dekodierung der gesendeten Bitfolge, wobei der empfangene Signalpuls zur Maximierung des Signal-Stör-Verhältnisses genau in der Mitte abgetastet wird. In der Signalanalyse verwendet man das zurückgewonnene Clocksignal zur Beurteilung der Signalqualität anhand sogenannter Augendiagramme (Englisch: eye diagram) und anderer mathematischer Werkzeuge zur Jitteranalyse.

Der Sendetakt wird oft mittels einer PLL (Englisch: Phase-Locked Loop), eines phasengekoppelten Regelkreises, ermittelt. Zur Signalqualitätsanalyse schreiben verschiedene Standards einen normierten Empfänger in der Form von PLL-Eigenschaften vor. Das zurückgewonnene Clocksignal bestimmt in diesem Zusammenhang definitionsgemäß den idealen Bitbeginnzeitpunkt. Die Auswertung der Abweichungen zwischen den Nulldurchgängen im empfangenen Datenstrom und im Clocksignal bildet die Grundlage der Jitteranalyse.

Zur Signal- bzw. Jitteranalyse wird der Sendetakt grundsätzlich auf zwei verschiedene Weisen zurückgewonnen:

- Die PLL wird mit Bausteinen in Hardware realisiert. Der Anwender speist den zeitkontinuierlichen Datenstrom in die PLL ein und erhält ein zeitkontinuierliches Clocksignal und den um die Verarbeitungslatenz verzögerten Datenstrom zurück. Datenstrom und Clocksignal sind miteinander synchronisiert. Das Verfahren arbeitet online in Echtzeit, der Datenstrom wird ständig beobachtet.
- Die PLL wird in Software mit einer Rechenvorschrift nachgebildet. Ein Messgerät nimmt einen Abschnitt des Datenstroms auf und wendet den Taktrückgewinnungsalgorithmus darauf an. Daraus wird das Clocksignal für den aufgenommenen Datenabschnitt zurückgewonnen. Das Verfahren arbeitet in der Regel offline, denn die Verarbeitungszeit des Algorithmus ist höher als die zeitliche Dauer des aufgenommenen Datenabschnitts.

Im Stand der Technik bekannte Hardware-PLLs können in drei Kategorien gegliedert werden: Lineare PLLs, digitale PLLs und volldigitale PLLs (Englisch: All-Digital PLL). Alle drei PLL-Typen verarbeiten und erzeugen analoge, zeitkontinuierliche Signale, wobei die digitale und volldigitale PLLs an die Verarbeitung von binären seriellen Datenströmen angepasst sind.

Mit Software-PLL bezeichnet man allgemein eine Rechenvorschrift, welche die Funktionsweise einer Hardware-PLL nachbildet. Ein Ansatz besteht darin, die Arbeitsweise der analogen Bausteine mathematisch zu beschreiben und damit eine hoch abgetastete Version des empfangenen Datenstroms zu verarbeiten. Ein zweiter Ansatz basiert auf der Beobachtung, dass nur die Nulldurchgänge im Datenstrom die relevante Information für die Taktrückgewinnung enthalten. In diesem Fall ermittelt man zunächst die Lage der Nulldurchgänge durch Interpolation des gespeicherten Datenabschnitts und berechnet anschließend daraus die Nulldurchgänge des Clocksignals.

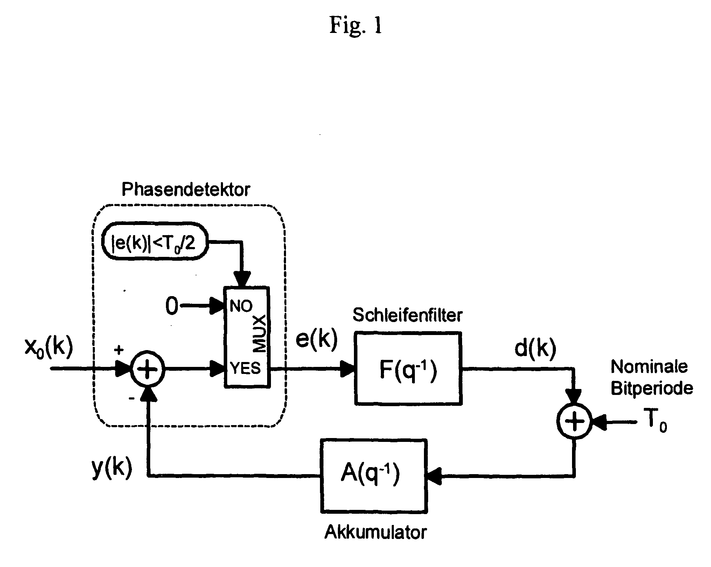

**Figur 1** zeigt die vereinfachte Struktur einer Software-PLL gemäß dem Stand der Technik. Das Eingangssignal $x_0(k)$ ist eine Liste mit der zeitlichen Position der Nulldurchgänge im Datenstrom, im Folgenden auch Datenflanken genannt. Mit y(k) werden die berechneten Clockflanken bezeichnet. Die PLL generiert nur eine Clockflanke pro Bitperiode. Stellt man sich das zugrunde liegende, zeitkontinuierliche Clocksignal als eine Sinusschwingung vor, dann bezeichnet y(k) die Zeitpunkte mit Phase gleich 0.

Die $x_0(k)$ sind chronologisch geordnet und werden sequenziell verarbeitet. Zunächst wird im Phasendetektor die Zeitdifferenz e(k) zwischen Daten- und Clockflanken gebildet. Da kein Signaldurchgang stattfindet, wenn der Sender zwei oder mehr gleiche Bits nacheinander überträgt, ist die Datenflankenanzahl in der Regel kleiner als die Anzahl übertragener Bits.

Die Software-PLL gewinnt den unterliegenden Takt in der Form einer Folge von Clockflanken *y(k)* zurück. Die Verarbeitungsschritte sind beispielsweise:

Phasen- bzw. Timing-Fehler:     $e(k) = x_0(k) - y(k)$

Behandlung von Flankenlücken:     a) Wenn $|e(k)| < T_0/2$ setze $e(k) = 0$ und verwerfe $x_0(k)$;

(fortgesetzt)

| | |
|---|---|
| | b) Wenn $|e(k)| > T_0/2$, setze $e(k) = 0$ und behalte $x_0(k)$ für die nächste Iteration. |
| Gefilterter Fehler: | $d(k) = F(q^{-1}) \cdot e(k)$ |
| Momentane Bitperiodenschätzung: | $T_b(k) = T_0 + d(k)$ |
| Nächste Clockflanke: | $y(k+1) = q \cdot A(q^{-1}) \cdot T_b(k)$ |

Durch gezielte Wahl der Koeffizienten von $F(q^{-1})$ und $A(q^{-1})$ kann diese Software-PLL, solange sie offline arbeitet, die theoretische PLL-Übertragungsfunktion sehr gut approximieren. Bei einer in Echtzeit arbeitenden Realisierung soll man beachten, dass jeder der obigen Verarbeitungsschritte eine gewisse Verarbeitungszeit erfordert. Die gesamte realisierungsbedingte Verzögerung verfälscht die Übertragungsfunktion des Regelkreises und kann sogar die Stabilität gefährden. Als Faustregel ist eine echzeitfähige Software-PLL gemäß dem Stand der Technik nur zur Analyse von Datenströmen einsetzbar, deren Bitperiode $T_b$ größer als die Verarbeitungszeit zur Berechnung einer neuen Clockflanke $T_{MIN}$ ist.

GB 2 359 223 offenbart eine digitale Taktrückgewinnung entsprechend dem Oberbegriff von Anspruch 1, und Anspruch 2.

AUFGABE DER ERFINDUNG

Aufgabe der vorliegenden Erfindung ist, ein Verfahren und eine Vorrichtung zur Taktrückgewinnung bereit zu stellen, die die Clockflankenpositionen durch die Verarbeitung von Datenflanken ermittelt und bei welcher die minimale analysierbare Bitperiode möglichst klein ist.

KURZE ZUSAMMENFASSUNG DER ERFINDUNG

Diese Aufgabe wird gelöst durch ein Verfahren und eine Vorrichtung zur Taktrückgewinnung gemäß den unabhängigen Patentansprüchen. Vorteilhafte Ausführungsformen sind in den abhängigen Patentansprüchen definiert.

Ein Verfahren zur Rückgewinnung eines Clocksignals aus einem Datensignal, wobei die Flanken des Daten- und des Clocksignals jeweils durch eine geordnete Sequenz von Zeitpunkten dargestellt werden, umfasst die Schritte:

- Bestimmen von Flankenlücken in der Sequenz der Datensignalflanken;
- Einfügen von neuen Datensignalflanken in die Sequenz von Datensignalflanken, um eine vervollständigte Sequenz von Datensignalflanken zu erhalten; und
- Rückgewinnung des Clocksignals aus der vervollständigten Sequenz von Datensignalflanken.

Erfindungsgemäß basiert das Erkennen von Flankenlücken in der Sequenz von Datensignalflanken auf einer Prädiktion des Clocksignals (FRONT CLOCK).

Mit anderen Worten wird der Regelkreis aus **Figur 1** so umgeformt, dass Flankenlücken außerhalb des eigentlichen Regelkreises erkannt und ausgefüllt werden und der PLL-Kern somit nur aus dem Schleifenfilter $F(q^{-1})$, dem Akkumulator $A(q^{-1})$, dem Addierer zur Ermittlung des Phasenfehlers $e(k)$ und $T_0$ besteht. Diese Verarbeitung lückenbehafteter Signale beruht auf einer prädiktiven Zuordnung der Clock- und Datenflanken. Flankenlücken, die etwa aufgrund der Übertragung mehrerer gleicher Bits nacheinander entstehen, können erkannt und gesondert behandelt werden, beispielsweise durch Interpolation.

Die Verlagerung der Behandlung von Flankenlücken außerhalb des Regelkreises gemäß der Erfindung bedeutet eine Vereinfachung des Regelkreises durch eine Verringerung der Arbeitsschritte im Regelkreis. Hieraus lässt sich die minimale analysierbare Bitperiode $T_{MIN}$ verkleinern. Darüber hinaus ergibt sich die Möglichkeit, den vereinfachten Regelkreis in eine äquivalente Struktur zur parallelen Verarbeitung mehrerer aufeinanderfolgender Datenflanken umzuformen (Blockfilterung), was den Durchsatz der Software-PLL um ein Vielfaches erhöht.

Durch die verlagerte Flankenlückenbehandlung wird im System zwar ein zusätzlicher Fehleranteil eingeführt. Je kleiner die Prädiktionstiefe, die PLL-Bandbreite und das Verhältnis von Flankenlücken zu übertragenen Bits, desto besser wird das vorgeschlagene Taktrückgewinnungsverfahren jedoch das Verhalten der ursprünglichen Software-PLL aus **Figur 1** approximieren.

Vorteilhafte Ausführungsformen werden im Folgenden skizziert.

KURZE BESCHREIBUNG DER ZEICHUNGEN

In der Zeichnung zeigen

Fig. 1    ein Blockschaltbild einer datenflankenverarbeitenden Soft- ware-PLL gemäß dem Stand der Technik;
Fig. 2    ein Blockschaltbild einer Software-PLL gemäß einer ersten Ausführungsform der Erfindung;
Fig. 3    ein Blockschaltbild einer Software PLL gemäß einer zweiten Ausführungsform der Erfindung;
Fig.4     die Paarung von Daten- und Clockflanken (Flankenzuord- nung);
Fig. 5    den Phasenoffset bei der Flankenzuordnung;
Fig. 6    die Bestimmung der effektiven Clockflankenanzahl;
Fig. 7    zwei Methoden zur Flankenzuordnung;

## DETAILLIERTE BESCHREIBUNG DER ERFINDUNG

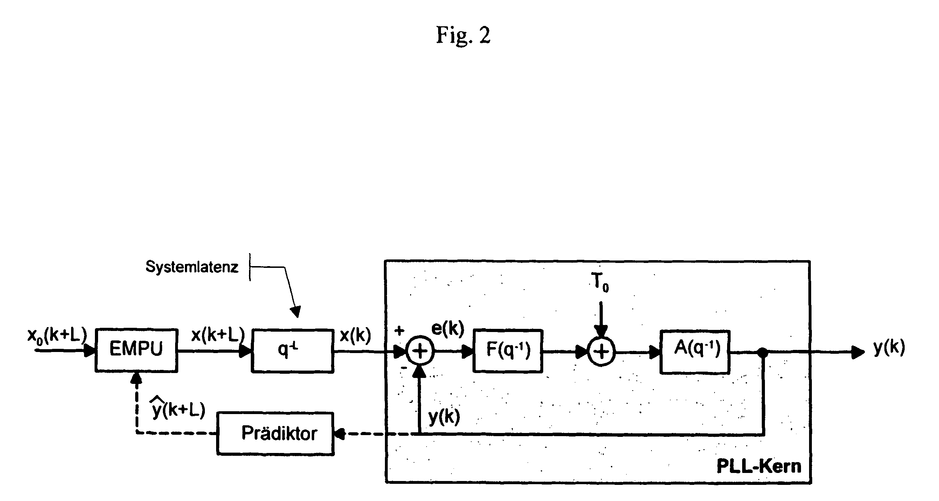

**Figur 2** zeigt ein Blockschaltbild einer ersten Ausführungsform der Erfindung. Zunächst findet gemäß der Erfindung eine prädiktive Zuordnung von Clock- und Datenflanken sowie eine Bestimmung von Flankenlücken in dem mit EMPU bezeichneten Block statt (Edge Matching and Patching Unit). Für diese Aufgabe nutzt die EMPU eine Prädiktion der Clockflanken $\hat{y}(k + L)$. Die Prädiktion ist erforderlich, weil die Dauer der Verarbeitung in der EMPU und im PLL-Kern insgesamt eine Systemlatenz von L Datenflanken einführt. Mit Hilfe von $\hat{y}(k + L)$ ermittelt die EMPU aus der rohen Datenflankenfolge $x_0(k + L)$, welche in der Regel mehrere Flankenlücken aufweist, eine interpolierte, lückenlose Datenflankenfolge $x(k + L)$.

Diese Folge von Datenflanken $x(k)$ wird sodann im Hauptregelkreis der PLL, im Folgenden auch PLL-Kern genannt, verarbeitet, um die Clockflanken $y(k)$ zu bestimmen. Der Hauptregelkreis umfasst einen Schleifenfilter $F(q^{-1})$, einen Akkumulator $A(q^{-1})$, einen Addierer zur Ermittlung des Phasenfehlers $e(k)$ und den Beitrag der nominalen Bitperiode $T_0$.

Die gestrichelte Linie weist darauf hin, dass die EMPU mit dem Hauptregelkreis beispielsweise über die zurückgewonnenen Clockflanken $y(k)$ gekoppelt ist.

Funktionsweise und günstige Ausführungsformen der EMPU werden im Folgenden erläutert.

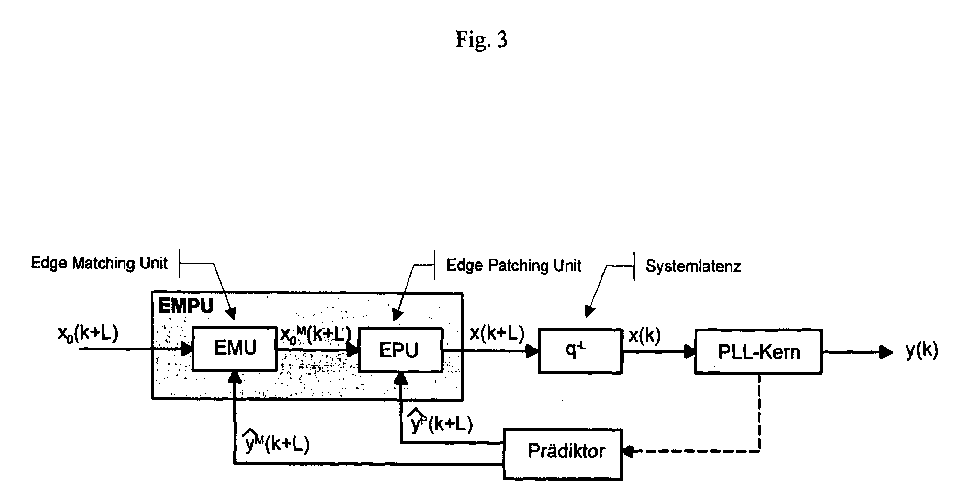

**Figur 3** zeigt ein Blockschaltbild einer Software-PLL gemäß einer zweiten Ausführungsform der Erfindung. Die EMPU kann in einen mit EMU (Edge Matching Unit) bezeichneten Block zur Zuordnung von Daten- und Clockflanken und einen mit EPU (Edge Patching Unit) bezeichneten Block zum Ausfüllen von Flankenlücken unterteilt werden.

In der Edge Matching Unit (EMU) werden zunächst die ankommenden Datenflanken einer bestimmten Bitperiode zugeordnet und dadurch die Flankenlücken erkannt. Die EMU nutzt die Clockflankenprädiktion $\hat{y}^M (k + L)$, um in die Datenflankenfolge $x_0(k + L)$ bei den Flankenlücken Platzhalter einzufügen. Anschließend werden die Flankenlük- kenplatzhalter in der Edge Patching Unit (EPU) durch einen geeigneten Wert ersetzt. Daraus resultiert die interpolierte, lückenlose Datenflankenfolge $x(k + L)$.

Ein Prädiktor liefert zwei Flankenfolgen. Die EMU kann eine Clockflankenprädiktion $\hat{y}^M (k + L)$ nutzen, um die Zeitachse in aneinanderliegende Intervalle der Breite einer Bitperiode aufzuteilen und damit eine Zuordnung der Datenflankenpositionen zu den Intervallen durchzuführen. Die EPU kann die Folge $\hat{y}^P (k + L)$ zur Interpolation der Datenflanken nutzen, um somit ein gewünschtes Verhalten des Phasenfehlers $e(k)$ bei Flankenlücken im PLL-Kern hervorzurufen. Anwendungsbedingt können beide Folgen gleich sein.

Eine mögliche Funktionsweise der EMU soll im Folgenden näher dargestellt werden.

## FLANKENZUORDNUNG

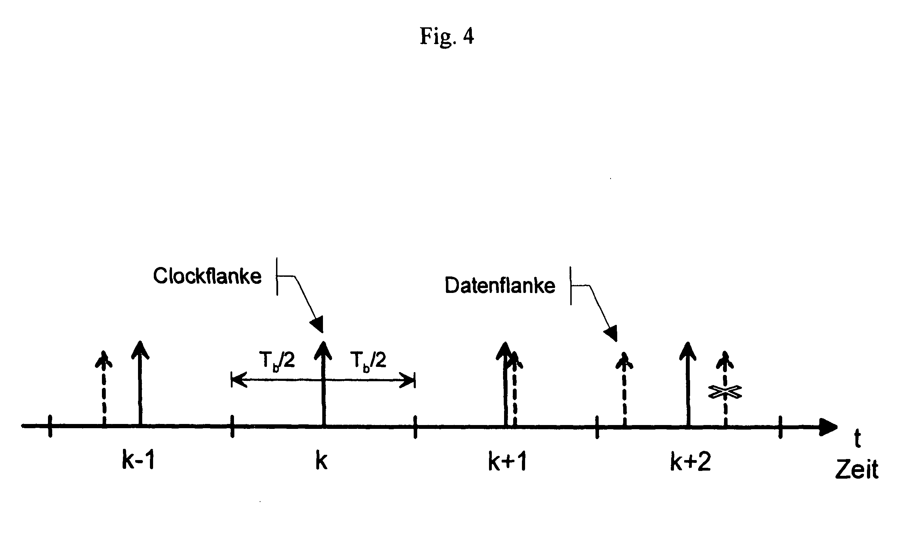

**Figur 4** zeigt an einem Beispiel das grundlegende Problem der Zuordnung von Daten- und Clockflanken. Die Datenflanke $x_0(k)$ und Clockflanken $y(k)$ sind jeweils mit gestrichelten und durchgezogenen Pfeilen auf der Zeitachse eingetragen. Die zurückgewonnenen Clockflanken stellen definitionsgemäß die erwartete Lage der störungsfreien Datenflanken dar und werden für die Flankenzuweisung als Referenzpunkt genommen. Ausgehend von den Clockflanken wird die Zeitachse in aneinander liegende Intervalle aufgeteilt. Man stelle sich vereinfachend vor, dass jede Clockflanke in der Mitte eines Intervalls der Länge einer Bitperiode $T_b$ liegt.

Theoretisch können drei Fälle unterschieden werden:

1. Liegt eine einzige Datenflanke innerhalb eines bestimmten Intervalls, dann kann sie eindeutig zur entsprechenden Clockflanke zugeordnet werden (Indizes ‚k-1' und ‚k+1' in Figur 4).

2. Liegt keine Datenflanke in einem Intervall, kann eine sog. 'Flankenlücke' (Englisch: missing edge) vorliegen (Index ‚k'). Flankenlücken treten beim Übertragen der Folgen "...00..." oder "...11..." auf, denn zwischen den zwei Bits findet keinen Signalübergang statt. Flankenlücken können markiert und gesondert behandelt werden.

3. Mehrere Datenflanken im gleichen Intervall können auf Glitches im Signal, niedriges SNR oder eine noch nicht eingerastete PLL hindeuten. In diesem Fall kann eine Datenflanke beibehalten und die restlichen verworfen werden (Index 'k+2'). Alternativ können alle Flanken verworfen werden, da im Grunde alle gleich falsch sind.

Herkömmliche Software- oder Hardware-PLLs arbeiten grundsätzlich sequenziell und ermitteln die Clockflanke y(k+1) durch die Verarbeitung von früheren Daten- und Clockflanken bis zum Zeitindex k. Zur Flankenzuordnung gemäß der Erfindung ist jedoch eine Prädiktion $\hat{y}(k)$ der Clockflanken y(k) erforderlich, da die Clockflanke y(k) zu diesem Zeitpunkt noch nicht vorliegt.

Zu diesem Zweck definiert die EMU ein sekundäres Clocksignal, im Folgenden ‚Front Clock' genannt. Der Front Clock $\hat{y}_M(k)$ stellt eine Prädiktion der zurückgewonnenen Clockflanken y(k) dar und wird zur Aufteilung der Zeitachse für die Flankenzuordnung genutzt. Der Front Clock kann in einer Ausführungsform der Erfindung mit dem PLL-Kern und folglich mit dem zurückgewonnenen Clockflanken y(k) gekoppelt sein, wie die gestrichelte Linie in den Blockschaltbildern von Figur 3 andeutet.

In einer möglichen Ausführungsform schätzt der Front Clock die künftigen Clockflanken y(k) nach dem Ansatz "der PLL-Clock wird für die nächsten N Bitperioden mit der nominalen Bitperiode $T_0$ fortlaufen". Dieser Ansatz zur Bestimmung des Front Clocks $\hat{y}_M(k)$ ist für Implementierungszwecke günstig, denn $T_0$ ist ein bekannter Betriebsparameter, aber setzt kleine Prädiktionstiefen L und geringe Abweichung der momentanen Bitperiode $\hat{T}_b$ vom nominalen Wert $T_0$ voraus. Die Nichterfüllung der Prädiktionsannahme ruft einen Phasenoffset zwischen den Clockflanken y(k) und dem Front Clock hervor. Der Phasenoffset nach Einrasten der PLL auf einen Datenstrom mit konstanter Bitperiode $T_b$ lässt sich wie folgt approximieren

$$\varphi = \frac{T_b - T_0}{T_b} \cdot L \ [\text{UI}] \quad (\text{Unit Interval}) \quad (1)$$

wobei

$T_b:$     die Bitperiode des Datenstroms,
$T_0:$     die nominale Bitperiode,
$L:$     Prädiktionstiefe bzw. Verarbeitungslatenz gemessen in Anzahl von Bitperioden,

bezeichnen.

Verwendet man den Front Clock anstelle des PLL-Clocks zur Flankenzuordnung, dann bewirkt der Phasenoffset eine Verschiebung der zugrunde liegenden Zeitintervalle bezüglich ihrer idealen Lage. Bei dem in Figur 4 dargestellten Fall liegt die Datenflanke so ungünstig, dass die EMU sie aufgrund des Phasenoffsets irrtümlich zum k-ten Intervall zuordnet. Ein zu großer Phasenoffset kann die Einrasteigenschaften und Jitterrobustheit der Taktrückgewinnung merklich beeinträchtigen.

Ein verbessertes Verhalten erhält man in der Regel, wenn man den Front Clock nach dem Ansatz "der PLL-Clock wird für die nächsten N Bitperioden mit der zuletzt geschätzten momentanen Bitperiode $\hat{T}_b$ fortlaufen" bestimmt. Dieser Ansatz nutzt aus, dass die PLL aufgrund ihrer schmalen Bandbreite langsam auf Änderungen des Eingangssignals reagiert. So ist der Phasenoffset nach Einrasten auf einen Datenstrom konstanter Bitperiode $T_b$ gemäß (1) nun etwa $\varphi \approx 0$. Andere Pradiktionsansätze sind denkbar.

DATENFLANKEN IN EINEM ZEITFENSTER

In einem online arbeitenden System wird der Datenstrom ständig beobachtet. Regelmäßig, wie beispielsweise jeden Systemtakt, wird der Taktrückgewinnung ein Satz neuer Datenflanken über eine externe Hilfsvorrichtung bereitgestellt. Ein Systemtakt definiert ein bestimmtes Fenster auf der Zeitachse. Die Datenflanken müssen zu einem der im Fenster liegenden Clockflanke zugeordnet werden. Ist die Bitperiode des Datenstroms kleiner als das Zeitfenster bzw. den Systemtakt, kann dies durch eine parallel durchgeführte Flankenzuordnung behandelt werden.

Vor diesem Hintergrund lässt sich die Funktionsweise der EMU in zwei Unteraufgaben teilen. Zunächst werden mit Hilfe des Front Clocks die vom aktuellen Systemtakt bzw. aktuellen Zeitfenster gedeckten Clockflanken ermittelt. Anschließend werden die empfangenen Datenflanken mit den Clockflanken gepaart und damit auch die Flankenlücken ermittelt.

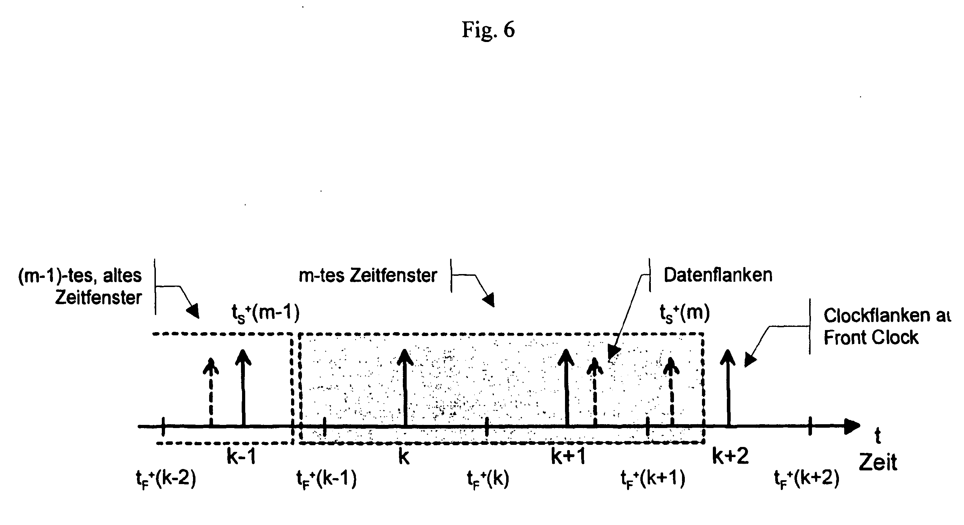

**Figur 6** zeigt beispielhaft Daten- und Clockflanken, die jeweils als gestrichelte und durchgezogene Pfeile auf der Zeitachse liegen. Das vom aktuellen Systemtakt definierte Zeitfenster ist mit grauem Hintergrund gekennzeichnet. Es gilt:

- Das k-te und (k+1)-te Intervall passen vollständig in das m-te Zeitfenster. Die eindeutige Zuordnung von Clock- und Datenflanken ist möglich.
- Der Teil des (k-1)-ten Intervalls, der noch nicht im (m-1)-ten Zeitfenster beobachtet wurde, wird vom aktuellen Zeitfenster abgedeckt. Nachdem das (k-1)-te Intervall vollständig belichtet wurde, ist auch hier eine eindeutige Flankenzuordnung möglich.

- Das (k+2)-te Intervall ist nur teilweise abgedeckt und kann nicht zur Flankenzuordnung freigegeben werden. Die bereits im Intervall liegende Datenflanke wird aufbewahrt und im nächsten Systemtakt ausgewertet.

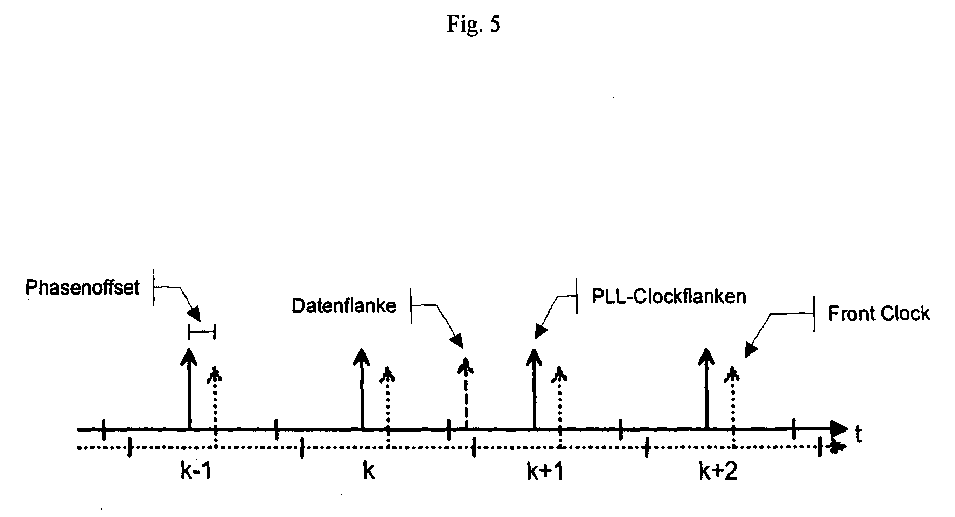

Der Front Clock gibt die Lage der Clockflanken $t_F(k)$ vor. Zur Bestimmung der vom aktuellen Zeitfenster gedeckten Zeitintervalle ist es hilfreich, die obere Grenze des k-ten Intervalls $t_F^{\leftrightarrow}(k)$, welche aus den Clockflanken beispielsweise gemäß $t_F^{\leftrightarrow}(k) = t_F(k) + T_0/2$ abgeleitet wird, mit der oberen Grenzen des m-ten Zeitfensters $t_S^{\leftrightarrow}(m)$ zu vergleichen. In Bezug auf Figur 5 gilt:

- $t_F^{\leftrightarrow}(k-1)$ wurde bereits bei der Auswertung des ($m$-1)-ten Zeitfensters berechnet und ist bekannt.

- $t_F^{\leftrightarrow}(k-1)$, $t_F^{\leftrightarrow}(k)$ und $t_F^{\leftrightarrow}(k+1)$ sind alle kleiner als $t_S^{\leftrightarrow}(m)$. Die entsprechenden Intervalle werden für die Flankenzuordnung freigegeben. Die Anzahl verarbeiteter Clockflanken ist drei.

- $t_F^{\leftrightarrow}(k+2)$ ist größer als $t_S^{\leftrightarrow}(m)$. Sowohl $t_F^{\leftrightarrow}(k+2)$ als auch die empfangene Datenflanke werden bis zum nächsten Systemtakt aufbewahrt.

Zusammenfassend wird die effektive Anzahl von Clockflanken im $m$-ten Zeitfenster dadurch bestimmt, wie viele $t_F^{\leftrightarrow}(k)$ zwischen die Zeitpunkte $t_S^{\leftrightarrow}(m-1)$ und $t_S^{\leftrightarrow}(m)$ passen.

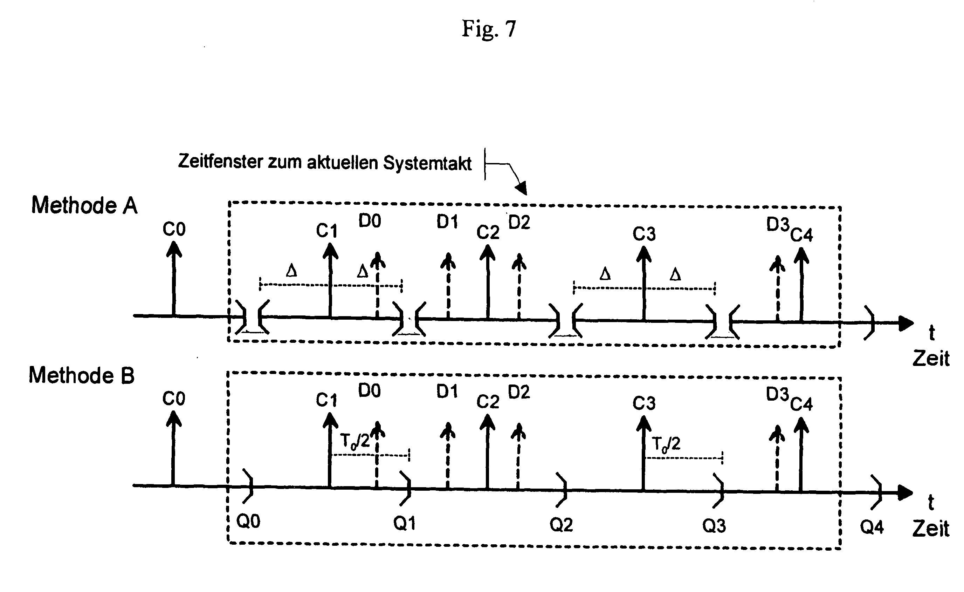

**Figur 7** stellt zwei mögliche Verfahren der Zuordnung von Daten- und Clockflanken dar. Im Zeitfenster sind vier Datenflanken enthalten, D0 bis D3. Die effektive Anzahl von Clockflanken ist auch vier: C0, C1, C2 und C3. C4 wird nicht verarbeitet, da ihre obere Zeitgrenze $t_F^{\leftrightarrow}(4)$ außerhalb des Zeitfensters liegt.

**Die Methode A** verbindet Daten- mit Clockflanken nach der Regel

$$\text{Wenn } |D_a - C_b| \leq \Delta \text{, dann passen } D_a \text{ und } C_b \text{ zusammen. } (a, b \geq 0), \qquad (2)$$

wobei $\Delta$ so gewählt wird, damit die Zeitachse in sich nicht überlappende Intervalle aufgeteilt wird. Datenflanken, die in die von den Intervallen nicht gedeckten Bereichen fallen, werden einfach ignoriert. Gemäß Figur 7 gilt

- C0 und C3 bleiben partnerlos und werden als Flankenlücken markiert.
- C1 ist mit D0 verbunden.
- D1 und D2 sollten zu C2 zugewiesen werden. Höchstens ist eine Datenflanke pro Clockflanke zugelassen, deswegen wird eine von den beiden ausgewählt. Das Auftreten einer Datenflankenkollision wird eventuell gemeldet.

Formell lässt sich die Flankenzuordnung in Matrixform mit folgender Tabelle beschreiben:

Tabelle 1 : Zuordnungsmatrix für Methode A.

| $\lvert D_a - C_b \rvert \leq \Delta$ | C0 | C1 | C2 | C3 |
|---|---|---|---|---|
| D0 | 0 | 1 | 0 | 0 |
| D1 | 0 | 0 | 1 | 0 |
| D2 | 0 | 0 | 1 | 0 |
| D3 | 0 | 0 | 0 | 0 |

Die Clock- und Datenflanken sind jeweils chronologisch sortiert. Unter der Annahme, dass pro Bitperiode höchstens eine Datenflanke entsteht, kann die Berechnung der Elemente in der unteren schattierten Dreiecksmatrix zum Senken des Rechenaufwandes übersprungen werden und defaultmäßig auf 0 gesetzt werden. Dies verringert jedoch die Robustheit der Zuordnungsmatrix für den Fall, dass mehrere Datenflanken pro Bitperiode auftreten, wie es z.B. beim Einrasten der PLL der Fall sein kann Ausführungsformen der Erfindung, bei welchen nur die Berechnung der Elementen der untersten Diagonalen übersprungen wird, sind ebenfalls möglich.

**Die Methode B** stellt eine alternative Ausführungsform des gleichen Ansatzes dar. Die Zeitachse wird hier über die Zeitpunkte $Q_b$ in aneinander liegende Intervalle aufgeteilt. Die $Q_b$ entsprechen den Zeitpunkten $t_F^+(k)$, welche zur Ermittlung der effektiven Clockflankenanzahl berechnet werden. Daten- und Clockflanken werden nun nach der Regel

$$\text{Wenn } Q_{b-1} < D_a \leq Q_b, \text{ dann passen } D_a \text{ und } C_b \text{ zusammen } (a, b \geq 0), \tag{3}$$

miteinander verknüpft. Daraus entsteht im betrachteten Beispiel die gleiche Zuordnungsmatrix wie bei Methode A. Flankenlücken werden angenommen, wenn Regel (3) nicht zutrifft.

INTERPOLATION DER FLANKENLÜCKEN

Die nach einer der beiden Methoden erkannten Flankenlücken werden gesondert behandelt. Gemäß der Erfindung interpoliert die EMPU $x_0(k)$ und erzeugt eine lückenlose Datenflankenfolge $x(k)$, welche dann vom PLL-Kern verarbeitet wird. Die Interpolation erfolgt beispielsweise durch Ausfüllen der Flankenlücken mit einer künstlichen Flanke. Dabei kann der Phasenfehler $e(k)$ durch geeignete Setzung der interpolierten Datenflanken so beeinflusst werden, dass die in der herkömmlichen PLL gemäß dem Stand der Technik verwendeten Verfahren zur Behandlung von Flankenlücken approximiert werden.

In der mit Bezug auf Figur 3 dargestellten Ausführungsform kann die EPU die Folge $\hat{y}^P(k + L)$ nutzen, um ein gewünschtes Verhalten des Phasenfehlers $e(k)$ bei Flankenlücken im PLL-Kern hervorzurufen. Beispielsweise kann in einer Ausführungsform der Erfindung eine Flankenlücke mit einer Prädiktion der Clockflanke ausgefüllt werden. Damit gilt im PLL-Kern:

$$e(k) = \hat{y}^P(k) - y(k) \approx 0$$

Andere Ansätze wie $e(k) = e(k-1)$ sind durch geeignete Wahl der interpolierenden Flanken realisierbar. Wenn beispielsweise $x_0^M(k + L - 1)$ eine Datenflanke ist und $x_0^M(k + L)$ eine Flankenlücke enthält, kann nach folgendem Ansatz verfahren werden:

$$x(k + L - 1) = x_0^M(k + L - 1)$$
$$x(k + L) = \hat{y}^P(k + L) = x(k + L - 1) + \hat{T}_b(k)$$

Hierbei ist zu beachten, dass zur Bestimmung von $x(k + L)$ aufgrund der Systemlatenz nur die um L Bitperioden verzögerte Schätzung der Bitperiode $\hat{T}_b(k)$ verfügbar ist. Wenn also eine neu eingefügte Datensignalflanke der Summe der zuletzt berechneten Datenflanke und der zuletzt geschätzten Bitperiode $\hat{T}_b(k)$ entspricht, berechnet sich der Phasenfehler $e(k)$ im PLL-Kern dann wie folgt:

$$e(k-1) = y(k-1) - x(k-1)$$
$$e(k) = y(k) - x(k) = y(k-1) + T_b(k) - (x(k-1) + \hat{T}_b(k))$$
$$= e(k-1) + (T_b(k) - \hat{T}_b(k-L)) \approx e(k-1)$$

D.h., dass eine Approximation eines Flankenfehlers e(k) gemäß der Gleichung e(k) = e(k-1), unter Berücksichtigung der Latenz L des Gesamtsystems, dadurch erzielt werden kann, dass zur Berechnung der Datenflanke mit der eine Flankenlücke ausgefüllt wird, die Summe aus der vorhergehenden Datenflanke und der um die Latenz L verzögerten Schätzung der Bitperiode gebildet werden kann, vorausgesetzt dass sich die momentane Bitperiode innerhalb der Systemlatenz L nur langsam ändert.

Alternativ kann statt der zuletzt geschätzten Bitperiode $\hat{T}_b(k)$ auch die nominale Bitperiode $T_0$ zu der letzten berechneten Datenflanke hinzuaddiert werden. Hierbei muss jedoch die Akkumulation der Bitperiodenabweichungen $\hat{\Delta}(k) = \hat{T}_b(k) - T_0$ beim Auftreten von mehreren Flankenlücken nacheinander beachtet werden. Mit anderen Worten wird der Approximationsfehler über Anzahl der aufeinander folgenden Flankenlücken akkumuliert und beträgt nach $N$ identischen Bits ca. $N(T_b - T_0)$. Die Übertragungsstandards definieren eine obere Schwelle für die Anzahl von gleichwertigen aufeinander folgenden Bits, daher ist N in der Praxis klein. Der kumulierte Fehler wird mit jeder Datenflanke in $x_0^M(k)$ automatisch zurückgesetzt.

Zusammenfassend kann also durch geeignete Wahl von $\hat{y}^P(k + L)$ das Phasenfehlerverhalten

$$e(k) = f(e(k-1), e(k-2), e(k-3), \ldots)$$

nachgebildet oder zumindest approximiert werden, wobei f(.) eine beliebige Funktion früherer Phasenfehlerwerte sein kann.

Obwohl das Ausfüllen der Flankefflücken zu Erläuterungszwecken in der EPU stattfindet, kann dies implementierungsabhängig an einer oder mehreren Stellen im Verarbeitungspfad zwischen Flankenlückenzuordnung und PLL-Kern realisiert sein.

**Patentansprüche**

1.   Verfahren zur Rückgewinnung eines Clocksignals aus einem Datensignal, wobei die Flanken des Daten- und des Clocksignals jeweils durch eine geordnete Sequenz von Zeitpunkten dargestellt werden, umfassend die Schritte:

   - Bestimmen von Flankenlücken in der Sequenz der Datensignalflanken;
   - Einfügen von neuen Datensignalflanken in die Sequenz von Datensignalflanken, um eine vervollständigte Sequenz von Datensignalflanken zu erhalten;
   - Rückgewinnung des Clocksignals aus der vervollständigten Sequenz von Datensignalflanken,

   **dadurch gekennzeichnet,**
   **dass** das Erkennen von Flankenlücken in der Sequenz von Datensignalflanken auf einer Prädiktion des Clocksignals basiert, und
   **dass** die Prädiktion des Clocksignals zur Flankenzuordnung mit dem Clocksignal gekoppelt ist.

2.   Verfahren gemäß Anspruch 1, wobei eine Flankenlücke dann erkannt wird, wenn zu einer prädizierten Clocksignalflanke $C_y$ keine Datensignalflanke $D_x$ existiert, so dass

$$\left| D_x - C_y \right| \le \Delta \quad x, y \ge 0 \,,$$

wobei D so gewählt wird, dass die Zeitachse in sich nicht überlappende Intervalle aufgeteilt wird.

3. Verfahren nach Anspruch 1, wobei eine Flankenlücke dann erkannt wird, wenn keine Datensignalflanke $D_x$ existiert, so dass

$$Q_{y-1} < D_x \le Q_y \quad x, y \ge 0 \,,$$

wobei die Zeitpunkte $Q_z$ die Zeitachse in aneinanderliegende Intervalle aufteilen.

4. Verfahren nach einem der Ansprüche 2 oder 3, wobei die neue Datensignalflanke gleich einer momentanen Prädiktion des Clocksignals ist.

5. Verfahren nach einem der Ansprüche 2 oder 3, wobei die neue Datensignalflanke gleich der Summe aus der letzten Datensignalflanke und einer momentan geschätzten Bitperiode ist.

6. Verfahren nach einem der Ansprüche 2 oder 3, wobei die neue Datensignalflanke gleich der Summe aus der letzten Datensignalflanke und einer nominalen Bitperiode $T_0$ ist.

7. Maschinell lesbarer Datenträger, der Instruktionen speichert, welche, ausgeführt durch einen Computer, ein Verfahren nach einem der vorhergehenden Ansprüche durchführen.

8. System zur Rückgewinnung eines Clocksignals aus einem Datensignal, wobei die Flanken des Daten- und des Clocksignals jeweils durch eine geordnete Sequenz von Zeitpunkten dargestellt werden, umfassend:

   - Mittel zum Bestimmen von Flankenlücken in der Sequenz der Datensignalflanken;
   - Mittel zum Einfügen von neuen Datensignalflanken in die Sequenz von Datensignalflanken, um eine vervollständigte Sequenz von Datensignalflanken zu erhalten;
   - Mittel zur Rückgewinnung des Clocksignals aus der vervollständigten Sequenz von Datensignalflanken,

   **dadurch gekennzeichnet,**
   **dass** das Mittel zum Erkennen von Flankenlücken in der Sequenz von Datensignalflanken ferner Mittel zur Prädiktion des Clocksignals umfasst, auf welcher die Erkennung basiert, und
   **dass** die Mittel zur Prädiktion des Clocksignals mit dem Mittel zur Rückgewinnung des Clocksignals zur Flankenzuordnung gekoppelt ist.

**Claims**

1. A method for the recovery of a clock signal from a data signal, wherein the edges of the data signal and the clock signal are each represented by an ordered sequence of timing points, comprising the following steps:

   - determination of missing edges in the sequence of data-signal edges;
   - insertion of new data-signal edges into the sequence of data-signal edges in order to obtain a completed sequence of data-signal edges;
   - recovery of the clock signal from the completed sequence of data-signal edges,

   **characterised in that**
   the identification of missing edges in the sequence of data-signal edges is based on a prediction of the clock signal, and
   that the prediction of the clock signal is coupled with the clock signal for the edge assignment.

2. The method according to claim 1, wherein a missing edge is identified if no data-signal edge $D_x$ exists for a predicted clock-signal edge $C_y$, so that

$$\left| D_x - C_y \right| \leq \Delta \quad x, y \geq 0 \ ,$$

wherein D is selected in such a mannner that the time axis is subdivided into non-overlapping intervals.

3. The method according to claim 1, wherein a missing edge is identified, if no data-signal edge $D_x$ exists, so that

$$Q_{y-1} < D_x \leq Q_y \qquad x, y \geq 0$$

wherein the timing points $Q_z$ subdivide the time axis into adjacent intervals.

4. The method according to any one of claims 2 or 3, wherein the new data-signal edge is equal to a momentary prediction of the clock signal.

5. The method according to any one of claims 2 or 3, wherein the new data-signal edge is equal to the sum of the last data-signal edge and a momentarily estimated bit period.

6. The method according to any one of claims 2 or 3, wherein the new data-signal edge is equal to the sum of the last data-signal edge and a nominal bit period $T_0$.

7. A machine-readable data medium, which stores instructions, which execute a method according any one of the preceding claims when exectuted by a computer.

8. A system for the recovery of a clock signal from a data signal, wherein the edges of the data signal and the clock signal are each represented by an ordered sequence of timing points, comprising

    - means for determining missing edges in the sequence of data-signal edges;
    - means for inserting new data-signal edges into the sequence of data-signal edges in order to obtain a completed sequence of data-signal edges;
    - means for recovering the clock signal from the completed sequence of data-signal edges,

**characterised in that**,
the means for identifying missing edges in the sequence of data-signal edges further comprises means for the prediction of the clock signal, on which the identification is based,
and that the means for the prediction of the clock signal is coupled with the means for the recovery of the clock signal for the edge assignment.

**Revendications**

1. Procédé de récupération d'un signal d'horloge à partir d'un signal de données, dans lequel les flancs du signal de données et du signal d'horloge sont représentés respectivement par une séquence ordonnée de points temporels, procédé comportant les étapes consistant à :

    - déterminer les pertes de flancs dans la séquence de flancs de signal de données ;
    - ajouter de nouveaux flancs de signal de données dans la séquence de flancs de signal de données, pour obtenir une séquence complète de flancs de signal de données;
    - récupérer le signal d'horloge à partir de la séquence complète de flancs de signal de données, **caractérisé en ce que**

la reconnaissance des pertes de flancs dans la séquence de flancs de signal de données est basée sur une prédiction du signal d'horloge, et

**en ce que** la prédiction du signal d'horloge est couplée au signal d'horloge pour l'affectation des flancs.

2. Procédé selon la revendication 1, dans lequel une perte de flancs est reconnue, lorsqu'il n'existe aucun flanc de signal de données $D_x$ pour un flanc de signal d'horloge prédit $C_y$, de sorte que

$$\left|D_x - C_y\right| \leq \Delta \qquad x, y \geq 0,$$

où D est choisi de sorte que l'axe des temps est divisé en intervalles qui ne se chevauchent pas.

3. Procédé selon la revendication 1, dans lequel une perte de flancs est reconnue, lorsqu'il n'existe aucun flanc de signal de données $D_x$, de sorte que

$$Q_{y-1} < D_x \leq Q_y \qquad x, y \geq 0,$$

où les points temporels $Q_z$ divise l'axe des temps en intervalles adjacents.

4. Procédé selon l'une des revendications 2 ou 3, dans lequel le nouveau flanc de signal de données est égal à une prédiction momentanée du signal d'horloge.

5. Procédé selon l'une des revendications 2 ou 3, dans lequel le nouveau flanc de signal de données est égal à la somme du dernier flanc de signal de données et d'une période de bits momentanément évaluée.

6. Procédé selon l'une des revendications 2 ou 3, dans lequel le nouveau flanc de signal de données est égal à la somme du dernier flanc de signal de données et d'une période de bits nominale $T_0$.

7. Support de données pouvant être lu par une machine, comportant des instructions, qui, lors de l'exécution sur un ordinateur, exécutent un procédé selon l'une quelconque des revendications précédentes.

8. Système pour récupérer un signal d'horloge à partir d'un signal de données, dans lequel les flancs du signal de données et du signal d'horloge sont représentés respectivement par une séquence ordonnée de points temporels, système comportant :

   - un moyen pour déterminer les pertes de flancs de données dans la séquence de flancs de signal de données ;
   - un moyen pour ajouter de nouveaux flancs de signal de données dans la séquence de flancs de signal de données, pour obtenir une séquence complète de flancs de signal de données ;
   - un moyen pour récupérer le signal d'horloge à partir de la séquence complète de flancs de signal de données,

**caractérisé en ce que**
le moyen pour reconnaître les pertes de flancs dans la séquence de flancs de signal de données comprend d'autres moyens pour la prédiction du signal d'horloge, à partir de laquelle est basée la reconnaissance, et
**en ce que** le moyen pour prédire le signal d'horloge est couplé au moyen pour récupérer le signal d'horloge en vue de l'affectation des flancs.

EP 2 191 607 B1

# Fig. 1

Fig. 2

## Fig. 3

Edge Matching Unit

Edge Patching Unit

Systemlatenz

EMPU

$x_0(k+L)$ → EMU → $x_0^M(k+L)$ → EPU → $x(k+L)$ → $q^{-L}$ → $x(k)$ → PLL-Kern → $y(k)$

$\hat{y}^M(k+L)$

$\hat{y}^P(k+L)$

Prädiktor

Fig. 4

Fig. 4

Fig. 5

Fig. 6

EP 2 191 607 B1

# Fig. 7

Zeitfenster zum aktuellen Systemtakt

Methode A

Methode B

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2359223 A